Europäisches Patentamt

European Patent Office

Office européen des brevets

(19)

(11) Veröffentlichungsnummer : **0 060 912**
**B1**

(12) **EUROPÄISCHE PATENTSCHRIFT**

(45) Veröffentlichungstag der Patentschrift :
22.10.86

(21) Anmeldenummer : 81102207.8

(22) Anmeldetag : 24.03.81

(51) Int. Cl.⁴ : **H 01 L 29/743**

(54) **Thyristor mit einem abschaltbaren Emitter-Kurzschluss.**

(43) Veröffentlichungstag der Anmeldung :
29.09.82 Patentblatt 82/39

(45) Bekanntmachung des Hinweises auf die Patenterteilung : 22.10.86 Patentblatt 86/43

(84) Benannte Vertragsstaaten :
FR GB SE

(56) Entgegenhaltungen :
DE-A- 2 643 935
DE-A- 2 733 060
DE-A- 2 825 794
DE-B- 2 625 917

(73) Patentinhaber : **Siemens Aktiengesellschaft Berlin und München**
**Wittelsbacherplatz 2**
**D-8000 München 2 (DE)**

(72) Erfinder : **Patalong, Hubert, Dr. Dipl.-Phys.**
**Kurt-Flöricke-Strasse 18**
**D-8000 München 60 (DE)**
Erfinder : **Platzöder, Karl, Dr. rer. nat.**
**Grete Hoffmann-Weg 22**
**D-8048 Haimhausen (DE)**

## Beschreibung

Die Erfindung bezieht sich auf einen Thyristor mit einem Halbleiterkörper, der eine außenliegende, mit einer streifenförmigen Elektrode versehene streifenförmige Emitterschicht des ersten Leitungstyps, eine außenliegende, mit einer Elektrode versehene Emitterschicht des zweiten Leitungstyps und zwei an diese jeweils angrenzende Basisschichten enthält, mit leitend miteinander verbundenen streifenförmigen Kurzschlußelektroden, die Teile der angrenzenden Basisschicht kontaktieren und neben der Emitterschicht des ersten Leitungstyps liegen, mit einem Feldeffekttransistor (FET), der die Kurzschlußelektroden mit der Elektrode der Emitterschicht des ersten Leitungstyps elektrisch verbindet.

Ein Thyristor dieser Art ist beispielsweise in der DE-B2-2 625 917 beschrieben worden. Der dort verwendete Feldeffekttransistor hat den Zweck, einen Kurzschluß zwischen der Emitterschicht und der angrenzenden Basiszone herzustellen und den Thyristor damit auszuschalten.

Die Erfindung geht von der Erkenntnis aus, daß die Abschaltwirkung eines solchen Thyristors um so besser ist, je schmaler die Emitterzonen sind und je geringer die zwischen der Emitterzone und der angrenzenden Basiszone liegende Spannung beim Abschalten ist. Für ein einwandfreies Abschalten muß die zwischen Emitterzone und Basiszone liegende Spannung kleiner sein als diejenige Spannung, bei der die aus Emitter und Basiszone bestehende Diode zu emittieren anfängt. Diese Spannung liegt bei einer Siliciumdiode bei etwa 0,6 bis 0,7 V.

Der Erfindung liegt die Aufgabe zugrunde, einen Thyristor der eingangs erwähnten Gattung so weiterzubilden, daß ein einwandfreies Abschalten, aber auch ein Einschalten in einfacher Weise möglich ist.

Diese Aufgabe wird dadurch gelöst, daß die Emitterschicht des ersten Leitungstyps in eine Mehrzahl von streifenförmigen Emitterzonen aufgeteilt ist, daß die streifenförmige Emitterelektrode in eine Vielzahl streifenförmiger, miteinander elektrisch verbundener Teile unterteilt ist, daß zwischen den streifenförmigen Emitterzonen je eine streifenförmige Kurzschlußelektrode liegt, daß diese Kurzschlußelektroden leitend miteinander verbunden sind, und daß der FET einen solchen Durchlaßwiderstand $R_{DS\ ON}$ im eingeschalteten Zustand hat, daß das Produkt aus Thyristorstrom einerseits und der Summe aus Bahnwiderstand unter den streifenförmigen Emitterzonen und dem Durchlaßwiderstand $R_{DS\ ON}$ andererseits kleiner als die am pn-Übergang zwischen Emitterzonen und Basisschicht liegende Spannung ist.

In der DE-B2-2 825 794 ist zwar bereits ein abschaltbarer Thyristor beschrieben, dessen Emitterzone in eine Vielzahl von einander parallelgeschalteten Teilemitterzonen aufgeteilt ist. Zwischen diesen Teilemitterzonen sind Basiselektroden angeordnet. Zwischen den einzelnen Teilemitterzonen und den Basiselektroden liegt ein Thyristor, der die genannten Teile kurzschließt. Da ein Thyristor jedoch eine höhere Durchlaßspannung als 0,6 bis 0,7 V hat, ist jeder Teilemitterzone noch ein ohmscher Widerstand und ein nichtlineares Bauelement in Reihe geschaltet. Damit wird diese Anordnung relativ aufwendig. Der ohmsche Widerstand macht sich außerdem im eingeschalteten Zustand des Thyristors durch erhöhte Verluste bemerkbar.

Weiterbildungen der Erfindung sind Gegenstand der Unteransprüche.

Die Erfindung wird nachfolgend anhand der Zeichnung näher erläutert. Dabei zeigen :

Figur 1 den Querschnitt eines ersten Ausführungsbeispiels,

Figur 2 eine Draufsicht der Anordnung nach Fig. 1.

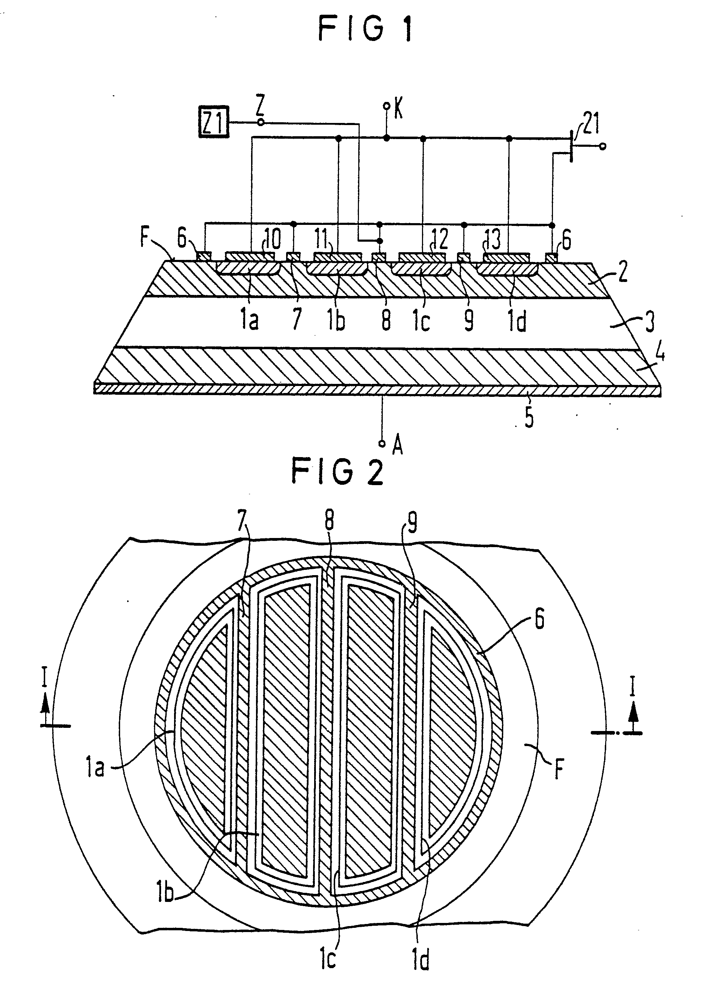

Der in Fig. 1 und Fig. 2 dargestellte Thyristor weist einen Halbleiterkörper mit Halbleiterschichten 1 bis 4 abwechselnder Leitfähigkeitstypen auf, die beispielsweise aus dotiertem Silizium bestehen. Dabei wird die außenliegende N-leitende Schicht 1, die aus Emitterzonen 1a bis 1d besteht, als N-Emitterschicht bezeichnet, die außenliegende P-leitende Schicht 4 als P-Emitterschicht. Die P-leitende Schicht 2 und die N-leitende Schicht 3 stellen die sogenannten Basisschichten dar. Die P-Emitterschicht 4 ist mit einer Anode 5 versehen, die einen Anodenanschluß A besitzt. Die Emitterzonen 1a bis 1d sind in Fig. 2 als vertikal verlaufende Streifen erkennbar, die parallel zueinander liegen und innerhalb einer ringförmigen Struktur 6 angeordnet sind. Diese ringförmige Struktur stellt den äußeren Teil einer Kurzschlußelektrode dar, der durch in Fig. 2 vertikal verlaufende Verbindungsstege 7 bis 9 ergänzt wird. Diese Stege stellen Kurzschlußelektroden dar, die jeweils neben den streifenförmigen N-Emitterzonen 1a bis 1d verlaufen. Aus Gründen der besseren Übersicht sind die Teile 6 bis 9 in Fig. 2 schraffiert dargestellt.

Aus der Fig. 1, die einen Querschnitt entlang der Linie I-I der Fig. 2 zeigt, ist entnehmbar, daß die streifenförmigen N-Emitterzonen 1a bis 1d jeweils mit Teilen 10 bis 13 einer Kathodenelektrode belegt sind, die untereinander leitend verbunden und an einen gemeinsamen Kathodenanschluß K geführt sind. Die Kurzschlußelektroden 7 bis 9 sind jeweils auf Teilen der Basisschicht 2 aufgebracht, die sich bis zur Grenzfläche F erstrecken. Die untereinander und mit dem Teil 6 leitend verbundenen Teile 7 bis 9 sind an den ersten Anschluß eines MOSFET 21 geführt, dessen zweiter Anschluß mit dem gemeinsamen Kathodenanschluß K in Verbindung steht. Liegt eine Steuerspannung am Gateanschluß, so ist der MOSFET 21 leitend, wobei die PN-Übergänge zwischen den Emitterzonen 1a bis 1d und der Basisschicht 2 über die Drain-Sourcestrecke jeweils kurzgeschlossen sind. Damit befindet sich der Thyristor im blockierten Zustand, in dem trotz einer in Durchlaßrichtung gepolten Spannung an den Anschlüssen A und K zwischen den letzteren praktisch kein Laststrom fließt. Die thermisch generierten Defektelektronen werden aus der Basisschicht 2 zur Kathode abgeleitet, so daß aus den N-Emitterzonen 1a bis 1d keine Ladungsträger in die Basisschicht 2 injiziert werden. Bei einer gleichmäßigen Verteilung der Kurzschlußelektroden 7 bis 9 innerhalb des Ringes 6 ergibt sich eine gute Stabilität des Thyristors gegen ungewollte Zündvorgänge.

Schaltet man nun den MOSFET 21 aus so werden die Emitter-Kurzschlüsse unwirksam. Es erfolgt die Zündung des Thyristors. Danach fließt ein Laststrom eines an A und K angeschlossenen Lastkreises über den niederohmig geschalteten Thyristor. Die Abschaltung desselben geschieht durch Anlegen einer Steuerspannung an den MOSFET.

Ein Teil des Thyristorstroms fließt nun über den FET zum Kathodenanschluß K. Dieser Teil ist um so größer, je kleiner der Widerstand des FET im eingeschalteten Zustand ($R_{DS\ ON}$) bei sonst gleichbleibender Dimensionierung des Thyristors ist. Zum Ausschalten muß das Produkt aus Thyristorstrom und der Summe aus Bahnwiderstand unter den Emittern und dem Widerstand $R_{DS\ ON}$ kleiner als die am pn-Übergang zwischen Emitter und Basisschicht liegende Spannung sein. Dann hört die Emitteremission auf.

Macht man die Emitter sehr schmal und hält ihre Abstände klein, z. B. jeweils 1 mm oder weniger, so ist bei üblichen Dotierungen unter den Emittern von z. B. $1 \cdot 16$ bis $8 \cdot 10^{17}$ Atome cm$^{-3}$ der Bahnwiderstand gegenüber dem $R_{DS\ ON}$ klein. Ein $R_{DS\ ON}$ von weniger als 0,1 $\Omega$ reicht damit aus, einen Abschaltstrom von 2 bis 3 A zu erzielen. Für höhere Abschaltströme muß $R_{DS\ ON}$ noch kleiner werden. Dies kann z. B. durch spezielle niedrigsperrende Leistungs-FET mit einem $V_{DS}$ von z. B. 50 V oder weniger erreicht werden, da der $R_{DS\ ON}$ mit sinkender maximaler Sperrspannung überquadratisch abfällt. Mit wachsender Fläche des FET läßt sich der Widerstand noch weiter verringern.

### Patentansprüche

1. Thyristor mit einem Halbleiterkörper, der eine außenliegende, mit einer streifenförmigen Elektrode versehene streifenförmige Emitterschicht des ersten Leitungstyps, eine außenliegende, mit einer Elektrode versehene Emitterschicht des zweiten Leitungstyps und zwei an diese jeweils angrenzende Basisschichten enthält, mit leitend miteinander verbundenen streifenförmigen Kurzschlußelektroden, die Teile der angrenzenden Basisschicht kontaktieren und neben der Emitterschicht des ersten Leitungstyps liegen, mit einem Feldeffekttransistor (FET), der die Kurzschlußelektroden mit der Elektrode der Emitterschicht des ersten Leitungstyps elektrisch vebindet, dadurch gekennzeichnet, daß die Emitterschicht des ersten Leitungstyps in eine Mehrzahl von streifenförmigen Emitterzonen (1a bis 1d) aufgeteilt ist, daß die streifenförmige Emitterelektrode in eine Vielzahl streifenförmiger, miteinander elektrisch verbundener Teile (10 bis 13) unterteilt ist, daß zwischen den streifenförmigen Emitterzonen je eine streifenförmige Kurzschlußelektrode (6 bis 9) liegt, daß diese Kurzschlußelektroden leitend miteinander verbunden sind, und daß der FET einen solchen Durchlaßwiderstand $R_{DS\ ON}$ im eingeschalteten Zustand hat, daß das Produkt aus Thyristorstrom einerseits und der Summe aus Bahnwiderstand unter den streifenförmigen Emitterzonen und dem Durchlaßwiderstand $R_{DS\ ON}$ andererseits kleiner als die am pn-Übergang zwischen Emitterzonen (1a bis 1d) und Basisschicht (2) liegende Spannung ist.

2. Thyristor nach Anspruch 1, dadurch gekennzeichnet, daß der FET (21) ein $R_{DS\ ON}$ von $\leq 0,1$ $\Omega$ hat.

3. Thyristor nach Anspruch 1 oder 2, dadurch gekennzeichnet, daß die Source-Drainstrecke des FET (21) unmittelbar zwischen den mit den Emitterzonen (1a bis 1d) verbundenen Elektroden (10 bis 13) und den Kurzschlußelektroden (6 bis 9) liegt.

4. Thyristor nach einem der Ansprüche 1 bis 3, dadurch gekennzeichnet, daß der FET in den Halbleiterkörper des Thyristors integriert ist.

### Claims

1. A thyristor having a semiconductor body which contains an outer strip-shaped emitter layer of the first conductivity type provided with a strip-shaped electrode, an outer emitter layer of the second conductivity type provided with an electrode, and two base layers adjacent respectively to the emitter layers, having strip-shaped short-circuiting electrodes which are conductively connected to one another and which contact parts of the adjoining base layer and are located beside the emitter layer of the first conductivity type, and having a field effect transistor (FET) which electrically connects the short-circuiting electrodes to the electrode of the emitter layer of the first conductivity type, characterised in that the emitter layer of the first conductivity type is divided into a plurality of strip-shaped emitter zones (1a, 1d); that the strip-shaped emitter electrode is divided into a plurality of strip-shaped parts (10 to 13) which are electrically connected to one another; that a strip-shaped short-circuiting electrode (6 to 9) is located between the strip-shaped emitter zones in each case; that these short-circuiting electrodes are conductively connected to one another; and that in the switched-on state, the forward resistance ($R_{DS\ ON}$) of the FET is such that the product of the thyristor current, on the one hand, and the sum of the bulk resistance beneath the strip-shaped emitter zones and the forward resistance $R_{DS\ ON}$, on the other hand, is smaller than the voltage connected to the pn-junction between the emitter zones (1a to 1d) and the base layer (2).

2. A thyristor as claimed in Claim 1, characterised in that the FET (21) has a $R_{DS\ ON}$ of $\leq 0.1\ \Omega$.

3. A thyristor as claimed in Claim 1 or Claim 2, characterised in that the source-drain path of the FET (21) is located directly between the electrodes (10 to 13), which are connected to the emitter zones (1a to 1d), and the short-circuiting electrodes (6 to 9).

4. A thyristor as claimed in one of Claims 1 to 3, characterised in that the FET is integrated into the semiconductor body of the thyristor.

## Revendications

1. Thyristor comportant un corps semiconducteur, qui contient une couche extérieure d'émetteur en forme de bande, possédant le premier type de conductivité et munie d'une électrode en forme de bande, une couche extérieure d'émetteur possédant le second type de conductivité et munie d'une électrode et deux couches de base jouxtant respectivement ces couches d'émetteur, et comportant des électrodes de court-circuit en forme de bandes reliées entre elles de façon conductrice et qui sont en contact avec des parties de la couche de base voisine et sont situées à côté de la couche d'émetteur possédant un premier type de conductivité, et comportant un transistor à effet de champ (FET), qui relie électriquement les électrodes de court-circuit à l'électrode de la couche d'émetteur possédant le premier type de conductivité, caractérisé par le fait que la couche d'émetteur possédant le premier type de conductivité est subdivisée en une multiplicité de zones d'émetteur en forme de bandes (1a à 1d), que l'électrode d'émetteur en forme de bande est subdivisée en une multiplicité d'éléments (10 à 13) en forme de bandes, qui sont reliés électriquement entre eux, que des électrodes respectives de court-circuit en forme de bandes (6, 9) sont disposées entre les zones d'émetteur en forme de bandes, que ces électrodes de court-circuit sont reliées entre elles de façon conductrice et que le transistor FET possède, à l'état conducteur, une résistance à l'état passant ($R_{DS\ ON}$) telle que le produit du courant du thyristor d'une part par la somme de la résistance de volume au-dessous des zones d'émetteur en forme de bandes et de la résistance à l'état passant ($R_{DS\ ON}$) d'autre part est inférieur à la tension présente au niveau de la jonction pn entre les zones d'émetteur (1a à 1d) et la couche de base (2).

2. Thyristor suivant la revendication 1, caractérisé par le fait que le transistor FET (21) possède une résistance ($R_{DS\ ON}$) $\leq 0,1\ \Omega$.

3. Thyristor suivant la revendication 1 ou 2, caractérisé par le fait que la voie source-drain du transistor FET (21) est située directement entre les électrodes (10 à 13), reliées aux zones d'émetteur (1a à 1d), et les électrodes de court-circuit (6 à 9).

4. Thyristor suivant l'une des revendications 1 à 3, caractérisé par le fait que le transistor FET est intégré dans le corps semiconducteur du thyristor.

FIG 1

FIG 2